(19) **Europäisches Patentamt / European Patent Office / Office européen des brevets**

(11) **EP 4 543 145 A1**

(12) # EUROPEAN PATENT APPLICATION

(43) Date of publication:
**23.04.2025 Bulletin 2025/17**

(21) Application number: **23204931.2**

(22) Date of filing: **20.10.2023**

(51) International Patent Classification (IPC):
**H05B 45/28** (2020.01)   **G01R 31/26** (2020.01)
**G01K 7/01** (2006.01)   **H05B 45/18** (2020.01)

(52) Cooperative Patent Classification (CPC):
**H05B 45/28; G01R 31/2635;** G01K 7/01;
H05B 45/18

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Melexis Technologies NV**
**3980 Tessenderlo (BE)**

(72) Inventors:
• **FROST, Raik**
**99099 Erfurt (DE)**
• **FREITAG, Thomas**
**99099 Erfurt (DE)**

(74) Representative: **Bardehle Pagenberg Partnerschaft mbB Patentanwälte Rechtsanwälte Prinzregentenplatz 7 81675 München (DE)**

(54) **METHOD FOR DETERMINING THE TEMPERATURE OF A LIGHTING DEVICE**

(57)   A method and an apparatus for determining the temperature of a light-emitting device is described. The method comprising operating (102) the light-emitting device (502) during an on-interval and during an off-interval, measuring (104), during at least one sensing interval, at least one electrical energy across the light-emitting device, wherein the at least one sensing interval is included in the off-interval and wherein each of the at least one sensing intervals has a duration equal to or less than a duration of the off-interval and determining (106), at least one temperature value of the light-emitting device (502) based on the measured at least one electrical energy.

100

| operating a light-emitting device during an on-interval and during an off-interval | 102 |

| measuring, during at least one sensing interval, at least one electrical energy across the light-emitting device, wherein the at least one sensing interval is included in the off-interval and wherein each of the at least one sensing intervals has a duration equal to or less than a duration of the off-interval | 104 |

| determining, at least one temperature value of the light-emitting device based on the measured at least one electrical energy | 106 |

Fig. 1

EP 4 543 145 A1

**Description**

TECHNICAL FIELD

The invention is related to a method for determining the temperature of a light-emitting device, in particular for sensing the temperature of a light-emitting diode, LED.

BACKGROUND

Today, more and more lighting tasks are fulfilled by LED technology. This is not only due to the improved energy efficiency and the lower thermal heating, but also because of the improved brightness, the lesser required mounting space, and the improved lifetime.

For example, in modern automobiles, front- and rear-lights are already frequently realized using LED technology. Similarly, interior lights within the car itself are often implemented using LEDs as, e.g., signal lamps. However, not only the automobile industry makes use of LED technology, but also other domains of technology and engineering where lighting with a given brightness and a desired colour is required. For example, modern architecture uses the potential of LED lighting to implement daylight-adapted lighting schemes, for which colour and brightness are steered dynamically in response to the daylight conditions outside of a building. However, also several other applications of LED technology are contemplated.

To steer the brightness and the colour of a lighting device as desired, a lighting device may include a plurality of different light-emitting devices of different colours, which emit light that is mixed to yield light having the desired brightness and colour. For example, a typical lighting device may include a red, a green and a blue LED, and the electrical energy supplied to the red, green and blue LED are adjusted such that the superposition of the light emitted by the LEDs features the desired brightness and colour. However, a lighting device may also include only one light-emitting device which can be driven differently to emit light of varying colour and brightness, e.g., an organic LED, OLED.

Unfortunately, there is a conflict between steering the brightness at the same time as the colour of light emitted from a lighting device. Depending on which brightness is chosen, the lighting device heats up in different ways and as such alters the colour which is emitted. For example, if the lighting device is driven in a high-brightness mode, it heats up more than when driven in a low-brightness mode. However, when the temperature of a lighting device changes, the colour of the lighting device changes, too. This effect can already be observed for traditional light bulb, which emits whiter light the more its filament is heated up. Similarly, the colour of an LED depends on its temperature. Thus, if the brightness of a lighting device is changed, the colour of the resulting light changes, too.

The effect of different device temperatures on the colour of the emitted light may be compensated for by adapting the amount of electrical energy supplied to one or more light-emitting devices, which may together constitute a lighting device, based on their individual temperatures. This approach may be referred to as temperature compensation. However, for this, a reliable temperature estimate is needed as a function of time for each of the light-emitting devices. This is even more important when the light-emitting devices are not located at the same position inside a lighting device, but at locations at certain distances from each other.

In the art, it is known that individual temperature sensors could be attached to each light-emitting device. For example, a semiconductor temperature sensor could be attached to each of a red, green and blue LED mounted in a common semiconductor package of a lighting device. However, the use of external temperature sensors is costly and requires additional mounting space. Furthermore, external temperature sensors never measure the temperature precisely at the location of a light-emitting device, but at a position offset from the light-emitting device. This requires complicated offset calculations.

Therefore, methods have been developed that use measurement of internal operating parameters, e.g., of voltage and/or current, of a light-emitting device to infer its temperature.

However, the existing methods have the drawback that the temperature measurement is performed without taking into account the operating cycle of the lighting device. Hence, it is not ensured that the temperature measurement itself does not disturb adjustment and maintenance of the desired brightness and colour.

Hence, there is a need for sensing a temperature of a light-emitting device, which overcomes the aforementioned disadvantages.

SUMMARY

This need is fulfilled by the method for determining the temperature of a light-emitting device and the corresponding electronic device according to the current invention.

The method for determining the temperature of a light-emitting device according to the current invention comprises operating the light-emitting device during an on-interval and during an off-interval.

A light-emitting device is an apparatus, which emits light when provided with energy. The energy may be provided in the form of electrical energy. The electrical energy may be quantized in the form of current and/or voltage applied to the light-emitting device. One non limiting example of a light-emitting device is thereby a light-emitting diode, LED.

The on-interval, as well as the off-interval are durations of time. The duration of the on-interval may be different from the duration of the off-interval. Thereby, the duration of the off-interval may be considerably shorter than the duration of the on-interval, e.g., by a factor of 10 ... 100 shorter than the duration of the on-interval. However, it is also possible that the on-interval and the off-interval have the same duration, or that the duration of the off-interval is longer than the duration of the on-interval.

During the on-interval and the off-interval, the light-emitting device may be operated using respective operating currents and/or operating voltages. The operating currents and/or operating voltages may also be referred to as operating electrical energy, which is supplied to the light-emitting device. It could also be said that, during the on-interval and the off-interval, the light-emitting device may be operated using a respective operating electrical energy. The operating electrical energy during the on-interval may be different from the operating electrical energy during the off-interval. The operating electrical energy during the on-interval may be constant in time or time-dependent. Likewise, the operating electrical energy during the off-interval may be constant in time or time-dependent. It could also be said that the operating electrical energies during the on-interval and/or during the off-interval may be DC or AC currents and/or voltages. It is also possible that the operating electrical energies during the on-interval and/or during the off-interval are piecewise DC currents and/or voltages and piecewise AC currents and/or voltages. Thus, it is possible that both, AC and DC currents and/or voltages, are provided to the light-emitting device during the on-interval and/or the off-interval. The peak electrical energy provided during the on-interval may be larger than the peak electrical energy provided during the off-interval. The total operating electrical energy provided to the light-emitting device during the on-interval may be larger than the total operating electrical energy provided to the light-emitting device during the off-interval. It could also be said that the total operating electrical energy provided to the light-emitting device during the off-interval is reduced as compared to the total operating electrical energy provided to the light-emitting device during the on-interval. Hence, the on-interval and the off-interval may not only differ in their duration, but also in the electrical energy provided to the light-emitting device during the respective time durations.

Alternatively, or additionally, any on-interval may be characterized with respect to an off-interval by means of the brightness of the emitted light. Operation of the light-emitting device using a respective operating electrical energy leads to that the light-emitting device emits light with a respective brightness and colour. It could also be said that adjusting the operating electrical energy supplied the light-emitting device defines the brightness and colour of the light emitted by the light-emitting device. Brightness is a photometric quantity, which characterizes the emitted power of the light emitted by the light-emitting device. The brightness is usually referred to as luminous flux, which is measured as lumen (lm). The brightness of the emitted light may be considerably augmented during the on-interval as compared to the off-interval. Similarly, the brightness of the emitted light may be considerably reduced during the off-interval as compared to the on-interval.

Colour is referred herein as a photometric quantity of a light-emitting device, which is measured by its wavelength, $\lambda$, and/or frequency, v. Any light emitted by a light-emitting device is characterized by its spectral radiance, i.e., by the relative distribution of radiant power as a function of the light wavelength, $\lambda$. As is known in the art, numerous RGB colour spaces can be defined, which have in common that a given perceived colour is fully described by three Tristumulus values, X, Y and Z. Three values arise since the human eye contains three types of cone cells (S, L, M) responsible for photoreception, which leads to trichromatic colour vision. Typical examples of RGB colour spaces are CIE RGB, CIE XYZ, NTSC and PAL/SECAM. More recent examples of RGB colour spaces are DCI-$P_3$, UHDTV and RIMM/ROMM. The three Tristumulus values X, Y, Z describing the colour of emitted light are obtained by integrating, over the wavelength, the spectral radiance of the emitted light multiplied by the respective of the three spectral sensitivity curves x($\lambda$), y($\lambda$) and z($\lambda$) of the CIE standard observer. It could also be said that the Tristumulus values X, Y and Z for a given stream of emitted light are obtained by projecting the spectral radiance of the emitted light on each of the three spectral sensitivity curves x($\lambda$), y($\lambda$) and z($\lambda$) of the CIE standard observer. In this way, each individual colour state of light emitted by a light-emitting device is characterized by another three-dimensional vector of Tristumulus values X, Y and Z.

Further, the method for determining the temperature of the light-emitting device according to the current invention comprises measuring, during at least one sensing interval, at least one electrical energy across the light-emitting device.

A sensing interval is a duration of time during which an electrical energy is measured. Each sensing interval may be characterized by its duration and by its location in time. It is possible that the electrical energy is measured once or multiple times during the same sensing interval. For example, electrical energy may be at least the voltage and/or current across the light-emitting device. Hence, the voltage and/or current across the light-emitting device may be measured. Furthermore, the measuring of the electrical energy may also comprise to measure other physical quantities based on which the voltage and/or current across the light-emitting device can be derived. For example, the resistance, the inductivity and/or the capacity across the light-emitting device may be measured. It is also possible that combinations of the voltage, the current, the inductivity and the capacity are measured across the light-emitting device simultaneously and/or consecutively.

During the sensing interval, an operating electrical energy, e.g. an operating current and/or voltage may be applied to the light-emitting device. The operating electrical energy applied during the sensing interval may also be called test electrical energy, e.g. a test current and/or a test voltage. The test electrical energy may be applied during the whole sensing interval, or only during one or more parts of the sensing interval. The test electrical energy may be considerably reduced as compared to the operating electrical energy applied during the on-interval. If a voltage is measured during the sensing interval, this voltage may be referred to as forward voltage. The forward voltage may be measured differentially. In particular, the forward voltage may be measured differentially with respect to the voltage to which the light-emitting device is connected. It could also be said that the forward voltage may be measured between a voltage source and the light-emitting device itself. When the forward voltage of the light-emitting device is measured, the current through the light-emitting device may be adjusted and limited by a current source equal to the test current. Also, when measuring the forward voltage of the light-emitting device differentially, the forward voltage may be given as the difference of the voltage over the voltage source minus the voltage at the current source. Additionally, or alternatively, a plurality of forward voltages of the light-emitting device may be measured during the at least one sensing interval. The plurality of forward voltages may be averaged to yield one mean forward voltage per sensing interval of the at least one sensing interval. However, the entirety and/or a subset of the measured plurality of forward voltages can also be stored without further processing. Hence, each of the at least one sensing intervals may be associated with one or more than one value for the forward voltage of the light-emitting device.

The at least one sensing interval may be is included in the off-interval of operating the light-emitting device. In other words, the off-interval may comprise at least one sensing interval. If a plurality of sensing intervals is comprised in the off-interval, the individual sensing intervals of the plurality of sensing intervals may be non-overlapping with each other and/or adjacent to each other. It could also be said that the off-interval may be covered with one or more sensing intervals.

Further, each of the at least one sensing intervals may have a duration equal to or less than a duration of the off-interval. This means that the beginning and the end of each of the at least one sensing interval are located inside the off-interval. The time location of the at least one sensing interval can be arranged freely within the duration of the off-interval. The sensing interval may occur at the beginning, the middle, or the end of the off-interval.

Finally, the method for determining the temperature of a light-emitting device according to the current invention comprises determining, at least one temperature value of the light-emitting device based on the measured electrical energy. The measured electrical energy may be correlated with and representative of the temperature of the light-emitting device. In general, the temperature of a light-emitting device is a function of the electrical energy provided to the light-emitting device. If no electrical energy is provided to the light-emitting device, the temperature of the light-emitting device is given by the ambient temperature. In general, if a voltage, U, and a current, I, are applied to a light-emitting device, the disposed power, P, equals P=U*I. The electrical energy, E, disposed in the light-emitting device equals the integral of the power, P(t), over time, t. A certain fraction of the disposed electrical energy, E, is dissipated in the light-emitting device and not emitted in the form of light energy. This leads to heating of the light-emitting device up to a temperature, T, which depends, among other material parameters, on the voltage, U, and the current, I. Thus, it could be said that the temperature, T, of the light-emitting device is a function T(U, I), wherein U and I are the voltage and current applied across the light-emitting device, respectively. Hence, the function T(U,I) may be used to determine at least one temperature value, T, if at least one voltage, U, and one current, I, measured across the light-emitting device are given. The temperature increase due to electrical power may be referred to as "over temperature", which comes on top of the ambient temperature. Hence, the function T(U, I), respectively the inverse of that function will give the ambient temperature or ambient temperature plus over temperature dependence if there is / was a temperature increase because of electrical power.

Furthermore, any light-emitting device may be characterized by a temperature-dependent resistance, R(T). For example, the resistance of a filament of a light bulb increases with increasing temperature. In contrast, the resistance of a light-emitting diode decreases with increasing temperature. Hence, if a temperature-dependent resistance, R(T), is given, voltage, U, and current, I, across the light-emitting device are related by R(T) = U/I and one of voltage, U, or current, I, may be substituted in the function T(U, I) for the temperature, T. For example, if the current, I, is substituted, a function T(U) results for the temperature, T, of the light-emitting device as a function of the voltage, U, supplied across the light-emitting device. If the voltage, U, is substituted, this yields a temperature T(I) as a function of the current, I, passed across the light-emitting device. Thus, using the function T(U), a temperature value, T, may be determined for each of the at least one measured voltage, U, across the light-emitting device. Likewise, the function T(I) may be used to determine a temperature value, T, for each of the at least one measured current, I, across the light-emitting device. It could also be said that the temperature, T, of the light-emitting device may be determined by evaluating one of the functions T(U, I), T(U) and/or T(I). Evaluating these functions may make use of numerical approximation of calibration measurements.

This allows for the first time to estimate the local temperature of a light-emitting device during continued operation, without disturbing delivery of emitted light having a desired brightness and colour.

In a preferred embodiment of the invention, the at least one sensing interval may be located at the beginning of the off-interval or at the end of the off-interval. When the at least one sensing interval is located at the beginning of the off-interval, the beginning of the at least one sensing interval coincides with beginning of the off-interval. In turn, when the at least one sensing interval is located at the end of the off-interval, the end of the at least one sensing interval coincides with the end of the off-interval. The at least one sensing interval being located at the beginning of the off-interval provides the technical advantage that the determined one or more temperatures are close to the temperature of the light-emitting device at the end of the on-interval. In this case, the temperature measurement constitutes an estimate of the maximum thermal stress exerted onto the light-emitting device since, when temperature is determined at the end of the on-interval, energy has already been disposed in the light-emitting device during the (whole) foregoing on-interval. If the light-emitting device is not supplied with electrical energy before the off-interval, the temperature measurement in the sensing interval located at the beginning of the off-interval may be used as an estimate for the ambient temperature. At the end of the on-interval, the light-emitting device usually reaches its maximum temperature. Thus, placing the sensing interval at the beginning of the off-interval helps to infer information about the maximum heat load inferred onto the light-emitting device during operation. This can be used, e.g., to adapt the length of the on-interval and/or the voltage and/or current applied to the light-emitting device during the on-interval to proactively steer aging effects of the light-emitting device. On the other hand, the at least one sensing interval being located at the end of the off-interval provides the technical advantage that the determined one or more temperatures are as close as possible to the temperature of the light-emitting device when the currents and voltages applied to the light-emitting device in the next on-interval are determined. This has the benefit that the desired brightness and colour for the next on-cycle can be adjusted with high precision since the dependency of brightness and colour of emitted light on the temperature of the light-emitting device could be taken into account, when determining the voltages and currents to be applied to the light-emitting device.

In a further embodiment of the invention, the off-interval may also comprise two sensing intervals during each of which at least one temperature value is determined as described above. One of the two sensing intervals may be located at the beginning of the off-interval while the other of the two sensing intervals may be located at the end of the off-interval. In this case, at least one temperature of the light-emitting device at the beginning of the off-interval as well as at least one temperature of the light-emitting device at the end of the off-interval are determined. These temperature values of the light-emitting device may be used for judging the fatigue of the light-emitting device undergone during the on-interval and to compensate for temperature effects, when steering currents and/or voltages of the light-emitting device to achieve a target brightness and colour in the next on-interval. The two sensing intervals may be separated by a gap. During the gap, the light-emitting device may be switched off, i.e., no operating current and/or voltage are applied. This allows the light-emitting device to recover from operation. The duration of the gap may be adapted to permit the light-emitting device to cool down to a desired baseline temperature. The desired baseline temperature may be adapted in such a way that the temperature at the end of the next on-interval does not exceed a desired maximum temperature.

In another preferred embodiment of the invention, the on-interval may be one of a plurality of on-intervals, and/or the off-interval may be one of a plurality of off-intervals. The on-intervals of the plurality of on-intervals may have the same durations or different durations. It is also possible that the on-intervals of one or more subsets of the plurality of on-intervals have a similar duration, wherein a respective similar duration is characteristic of a respective subset of the one or more subsets. Similarly, the off-intervals of the plurality of off-intervals may have the same durations or different durations. It is also possible that the off-intervals of one or more subsets of the plurality of off-intervals have a similar duration, wherein a respective similar duration is characteristic of the respective subset of the one or more subsets. Furthermore, the on-intervals of the plurality of on-intervals may alternate with the off-intervals of the plurality of off-intervals. Also, each on-interval of the plurality of on-intervals may be adjacent to two off-intervals of the plurality of off-intervals. In this case, the first of the two off-intervals may precede the on-interval, while the second of the two off-intervals may follow the on-interval. This has the advantage that light is emitted for a longer overall period than when only one on-interval is present. It could also be said that - through the presence of pluralities of on- and off-intervals - regular light emission is facilitated while recurring candidate intervals for temperature measurements are provided. It is also achieved that the light-emitting device is granted recurring recovery periods during the off-intervals of the plurality of off-intervals in which less energy is disposed in the light-emitting device as compared to the on-intervals. This augments the lifetime of the light-emitting device while ensuring proper delivery of light of the desired brightness and colour.

Further, the plurality of on-intervals may be periodic, and/or the plurality of off-intervals may be periodic. It could also be said that the on-intervals and/or the off-intervals are repeated. The repetition may be characterized by respective repetition times and frequencies. For example, the on-intervals may be repeated after a first repetition time and/or the off-intervals may be repeated after a second repetition time. The first and the second repetition time may be equal. In a special case, the first and the second repetition time may equal the duration of the on-interval plus the duration of the off-interval. It is also possible that the on-intervals of one subset of the plurality of on-intervals are repeated after a different repetition time than the on-intervals of another subset of the plurality of on-intervals. Likewise, it is possible that the off-intervals of one subset of the plurality of off-intervals are repeated after a different repetition time than the off-intervals of another subset of the plurality of off-intervals. This has the technical advantage that quasi steady-state operation of the light-emitting device is enabled, since periodically recurring on-intervals lead to light-emission with the desired brightness and colour properties. At the same time, the periodically recurring off-intervals allow for recovery periods associated with the periodically recurring on-intervals. Likewise, the on-intervals may be repeated with a first repetition frequency and/or the off-intervals may be repeated with a second repetition frequency. The first and second repetition frequencies may be chosen from a frequency between 100Hz and 2kHz. However, these values are only examples and do not limit the claimed invention.

Further, each off-interval of the plurality of off-intervals or each off-interval of a subset of the plurality of off-intervals may include at least one sensing interval. There exist different ways of including sensing intervals in the off-intervals of the plurality of off-intervals. In one embodiment, at least one sensing interval may be included in each of the off-intervals of the plurality of off-intervals. In this case, the cardinal number of the plurality of off-intervals is equal to or smaller than the total number of sensing intervals since each off-interval carries at least one sensing interval. In another embodiment, it is possible that only off-intervals included in a subset of the plurality of off-intervals include at least one sensing interval. In this case, the cardinal number of the plurality of off-intervals may be higher than the total number of sensing intervals. It could also be said that the sensing intervals may be sparsely distributed over the plurality of off-intervals. If the plurality of off-intervals is periodic, the off-intervals of the plurality of off-intervals could be ordered in ascending order with respect to their occurrence in time and only every $2^{nd}$, $10^{th}$ or $100^{th}$ off-interval of the plurality of time-ordered off-intervals could include at least one sensing interval. In this particular case, the subset of the plurality of off-intervals corresponds to every $2^{nd}$, $10^{th}$ or $100^{th}$ off-interval of the plurality of time-ordered off-intervals. Not including a sensing interval into every off-interval of the plurality of off-intervals has the technical benefit that a microcontroller, which serves for processing the measured electrical energies to obtain the associated temperatures of the light-emitting device, is unloaded with unnecessary calculations. In this way, a cost advantage for the needed calculation power of the microcontroller is provided.

In a further preferred embodiment of the invention, the operating the light-emitting device may comprise applying, during the on-interval, an operating electrical energy to the light-emitting device, and reducing, during the off-interval, the operating electrical energy. The operating electrical energy may comprise an operating current and/or operating voltage. Reducing the operating electrical energy during the off-interval means that the electrical energy is adjusted such that the total electrical energy supplied to the light-emitting device during the off-interval is smaller than the total electrical energy supplied during the on-interval. Thus, the operating electrical energy applied during the off-interval may be smaller than the operating electrical energy applied during the on-interval. In particular, the peak electrical energy applied during the off-interval may be smaller than the peak electrical energy applied during the on-interval. Thus, the operating electrical energy may be switched-off or lowered after the on-interval. However, it is also possible that the peak electrical energy applied during the on-interval is smaller than the peak electrical energy applied during the off-interval as long as it is ensured that less total electrical energy is supplied during the off-interval as compared to the on-interval. The off-interval may distinguish over the on-interval in terms of the brightness of the light emitted by the light-emitting device. To achieve a differing brightness between the light emitted during the on-interval as compared to the off-interval, a reduced electrical energy may be applied to the light-emitting device during the off-interval as compared to the on-interval. As a result, the light-emitting device may still emit light during the off-interval or may stay completely dark. However, the peak brightness of the light emitted during the off-interval may be lower than the peak brightness of the light emitted during the on-interval. It may also be said that the time integral of the radiant power of the emitted light over the on-interval is larger than the time integral of the radiant power of the emitted light over the off-interval. This does not exclude that the total energy of the light emitted during the off-interval is larger than zero. In other words, it could be said that the light-emitting device may still glim during the off-interval although this glim is perceived by the human eye as much less strong than the light emitted during the off-interval, or even not perceived at all by the human eye.

Further, during at least parts of the off-interval, the operating electrical energy may be reduced to zero. In this case, the light-emitting device is not anymore supplied with any electrical energy at all during at least the parts of the off-interval. Hence, these parts of the off-interval may be associated with a vanishing brightness and/or radiant power of the emitted light. This has the technical benefit that the light-emitting device is completely switched-off such that it can cool down again. In this way, too early aging effects of the light-emitting device and unnecessary thermal stress exerted onto the light-emitting device are avoided. However, during other parts of the off-interval, a residual brightness and/or radiant power of the emitted light may be present due to a non-vanishing applied electrical energy.

In a further preferred embodiment of the invention, the determining of the at least one temperature value may comprise estimating the at least one temperature value based on a correlation between temperatures of the light-emitting device and the electrical energy occurring across the light-emitting device. A correlation between two values is a dependency of the one of the two values on the other of the two values. It could also be said that, if a correlation is given, knowledge of the one value implicates knowledge of the other value. The temperature of a light-emitting device is related to the electrical energy occurring across the light-emitting device. For example, temperature is not independent of operating electrical energy. The dependency of the temperature on the operating electrical energy is a correlation in the above-mentioned sense. Thus, if the operating electrical energy is known, knowledge of a temperature value is implicated. The operating electrical energy may comprise an operating current and/or operating voltage. As outlined above, a function $T(U,I)$ may be used to infer at least one temperature value, $T$, for the at least one voltage, $U$, and one current, $I$, measured across the light-emitting device. The function $T(U,I)$ may be known in an analytical form as a formula. Hence, to infer the temperature from the measured voltage, $U$, and current, $I$, the function $T(U,I)$ may be evaluated at the point $(U,I)$. In particular, if the current, $I=I_o$, is fixed, the function $T(U,I)$, reduces to a function $T(U) = T(U, I=I_o)$, which links temperature, $T$, of the light-emitting device to the measured voltage, $U$, across the light-emitting device. As outlined above, a relation $R(T)$ may exist, which defines the resistance, $R$, of the light-emitting device as a function of its temperature, $T$. Hence, the reduced function $T(U)$ may also be given as $T(U) = T(U, U/R(T))$. Likewise, a reduced function $T(I)$ describing the temperature, $T$, of the light-emitting device as a function of the current, $I$, may be given as $T(I) = T(R(T)*I, I)$. Also, the functions $T(U)$ and/or $T(I)$ may be given in closed form as analytical formulas. Thus, if the temperature, $T$, of the light-emitting device is to be inferred from the measured voltage, $U$, or the measured current, $I$, across the light-emitting device, also the functions $T(U)$ and $T(I)$ may be evaluated. In one embodiment of the invention, the measured voltage may be the forward voltage. The functions $T(U,I)$, $T(U)$ and/or $T(I)$ need not to be present in analytical form but may also be saved in a numerical format. For example, the functions $T(U,I)$, $T(U)$ and/or $T(I)$ may be present as an indexed list of temperature values, $T[i]$, and voltage values, $U[i]$, and/or current values, $I[i]$, for a given number of data points $i=1...N$. Also, the functions $T(U,I)$, $T(U)$ and/or $T(I)$ may be saved as a look-up table for a given number of data points. This has the technical advantage that the relationship between temperature and electrical energy, for example, voltage and/or current, can be adapted to the light-emitting device, or to the type of the light-emitting device. For example, calibration measurements can be performed on the light-emitting device to yield the indexed list and/or the look-up table. The indexed list and/or lookup table may be saved to a memory or to a hard-drive. When estimating the temperature of the light-emitting device from a given measured voltage and/or current, the indexed list and/or lookup-table may be interpolated. In this way, sufficient accuracy for the temperature estimate can be achieved while at the same time memory space usage for the indexed list and/or lookup-table is optimized. The interpolation can make use of piecewise linear interpolation or linear regression. However, also higher-order and/or higher-dimensional interpolation schemes may be used that link more than two pairs of data points by non-linear functions, e.g., spline interpolation. In another example, a neural network may be trained based on temperature values, $T[i]$, and voltage values, $U[i]$, and/or current values, $I[i]$, for a given number of data points $i=1...N$.

If more than one electrical energy, i.e., a plurality of electrical energy values, are measured during the at least one sensing interval, more than one temperature value can be estimated for the at least one sensing interval. The maximum temperature of the more than one temperature values may be referred to as peak temperature in the at least one sensing interval. The peak temperature may trigger a reduction of the operating electrical energy, e.g. current and/or voltage, supplied to the light-emitting device and/or the delivery of an emergency feedback, if the peak temperature is perceived as being larger than a threshold temperature. This has the technical advantage to avoid damage to the light-emitting device.

Further, the method may comprise averaging at least a part of the electrical energies before estimating the at least one temperature value based on the correlation and/or averaging at least a part of the at least one temperature value after estimating the at least one temperature value based on the correlation. If more than one temperature value is estimated for the at least one sensing interval, these more than one temperature values may be averaged to yield an average temperature. It is also possible that a median of the more than one temperature values is formed. Such an average/median temperature value may be used to detect faulty temperature measurements. For example, the average/median temperature value may be compared to each of the estimated more than one temperature values. It might also be said that, if a particular temperature value of the more than one temperature values is detected to be an outlier among the more than one temperature values, this particular temperature value may be marked as an error. Such an error may arise, e.g., due to failures in electromagnetic compatibility, EMC, of the light-emitting device. If an average/median temperature value is of interest, it is also possible that at least a part of the measured electrical energies is averaged before an associated average/median temperature value is determined from the averaged electrical energies using the correlation. Thus, a single average/median electrical energy value may be determined from multiple electrical energy values. This single average/median electrical energy value can be transformed using the indexed list, the look-up table and/or the neural network to yield an associated single average/median temperature value. This has the technical advantage that the indexed list, lookup-table and/or neural network must only be evaluated once, which reduces the computational burden as compared to averaging and/or forming the median after temperature value estimation.

Also, the correlation may be based on a temperature gradient and a dedicated voltage and/or current across the light-emitting device, wherein the dedicated voltage and/or current corresponds to the voltage and/or current at a dedicated reference temperature of the light-emitting device. It could be said that, in this case, the measured at least one electrical energy may be a voltage and/or current across the light-emitting device and the correlation may be correlation between temperatures of the light-emitting device and voltages and/or currents across the light-emitting device. A gradient describes the linear slope of a function in one direction of the parameter space of the function. Hence, a temperature gradient describes the linear slope of the temperature in one direction of the parameters of the temperature. In one example, the functions $T(U,I)$, $T(U)$, and/or $T(I)$, which describe the dependency of the temperature on currents and/or voltages, might be approximated in a linear way. I could also be said that, in this case, the functions may be globally linear. In this case, each of the functions $T(U,I)$, $T(U)$, and/or $T(I)$ may be characterized by its slope and its intercept. Thus, the slope may be a temperature gradient, *grad*(T), and the intercept may be a dedicated reference temperature, $T_d$, which - via the functions $T(U,I)$, $T(U)$, and/or $T(I)$ - corresponds to a dedicated reference voltage, $U_d$, and/or reference current, $I_d$. These two values - slope and intercept - define fully the local linear approximation of each of the functions $T(U,I)$, $T(U)$, and/or $T(I)$. In another example, it is possible that a plurality of local temperature gradients together with a corresponding plurality of local dedicated reference temperatures is stored. It could also be said that, in this case, the functions may be piecewise linear. Thus, the global behaviour of the functions $T(U,I)$, $T(U)$, and/or $T(I)$ may be represented by piecewise linear interpolation using the plurality of local gradients and the corresponding plurality of local dedicated reference temperatures. In even another example, the global behaviour of the functions $T(U,I)$, $T(U)$, and/or $T(I)$ might be approximated using non-linear base functions. For example, the functions could be approximated by polynomials of different order, especially using spline interpolation, or by Fourier decomposition. It could also be said that, generally, the functions $T(U,I)$, $T(U)$, and/or $T(I)$ may be decomposed as a series over any complete set of base functions. In this case, the coefficients of the series, i.e., the projections of the functions $T(U,I)$, $T(U)$, and/or $T(I)$ onto each base function of the set of base functions, may be stored and used when the functions $T(U,I)$, $T(U)$, and/or $T(I)$ are to be evaluated at arguments U and/or I, which do not coincide with the support on which the functions $T(U,I)$, $T(U)$, and/or $T(I)$

have been sampled such that interpolation is necessary.

Further, the temperature gradient may be the same for a set of light-emitting devices having the same type as the light-emitting device. In one example, some coefficients for the above-mentioned development of the functions $T(U,I)$, $T(U)$, and/or $T(I)$ into a series over a complete set of base functions may depend individually on the light-emitting device. For example, the intercept for linear interpolation may be an individual parameter of each individual light-emitting device. If the light-emitting device is a red, green or blue LED, the intercept at temperature T=0°C amounts typically to a value for the forward voltage in the range 1V ... 4V. However, in another example, some coefficients for the above-mentioned development of the functions $T(U,I)$, $T(U)$, and/or $T(I)$ into a series over a complete set of base functions may be independent of the individual light-emitting device. These coefficients may also be termed 'common coefficients' since they are shared by a plurality of light-emitting devices, e.g., of the same type. In contrast, the coefficients which differ for each light-emitting device could be termed 'individual coefficients'. For example, the temperature gradient for linear interpolation may only depend on the type of the light-emitting device, but not on the individual light-emitting device as such. If the light-emitting device is a red, green or blue LED, the temperature gradient with respect to the forward voltage amounts typically to a value in the range -1mV/K ... -5mV/K. It could also be said that, in this case, if a plurality of light-emitting devices is fabricated, each light-emitting device of the plurality of fabricated light-emitting devices may have the same temperature gradient. Hence, the intercept for linear interpolation may be an individual coefficient while the temperature gradient for linear interpolation may be a common coefficient. This provides the technical benefit that the common coefficients must be initialized only once for every set of light-emitting devices of the same type. This provides a cost advantage if more than one light-emitting device of a particular type is used.

In a further preferred embodiment of the invention, the method may further comprise applying, during the at least one sensing interval, a test electrical energy to the light-emitting device. The test electrical energy may comprise a test electrical voltage and/or test electrical current. A test electrical energy is an electrical energy which has a different purpose than the operating electrical energy. During provision of a test electrical energy, operation of the light-emitting device may still occur but may be negligible. For example, if one of a test voltage or test current is applied, the other one of voltage or current may be measured. The resistance, $R(T)$, of any light-emitting device, which links current and voltage applied to the light-emitting device, is a function of the temperature, T, of the light-emitting device. Hence, if a test voltage, $U_{test}$, is applied to the light-emitting device, and the current, I, is measured, this determines the temperature, T, of the light-emitting device, according to Ohm's law, $R(T) = U_{test}/I$. Likewise, if a test current, $I_{test}$, is applied to

the light-emitting device, and the voltage, U, is measured, this determines the temperature, T, of the light-emitting device, again according to Ohm's law, $R(T) = U/I_{test}$. In particular, the measured voltage, U, may be the forward voltage across the light-emitting device. If the light-emitting device is a red, green or blue LED, the test current typically amounts to $I_{test} \sim 500\mu A$ while the measured forward voltage, U, typically amounts to U = 1 ... 4V for a temperature range of T=-50°C ... 120°C of the LED. However, these values shall not be limiting but are given only as an example to illustrate the typical magnitude of the involved parameters. From the technical perspective, it could also be said that the test current, $I_{test}$, or the test voltage, $U_{test}$, could only be maintained under temperature changes, when the other one of current, I, or voltage, U, is adapted. If the temperature, T, changes, the resistance, $R(T)$, changes, too. However, to ensure that Ohm's law is respected, $R(T) = U/I$, fixing one of current, I, or voltage, U, to be equal to a test current, $I_{test}$, or to a test voltage, $U_{test}$, respectively, requires adaptation of the other one of current, I, or voltage, U. This adapted current, I, or voltage, U, may be measured. The test current, $I_{test}$, or the test voltage, $U_{test}$, may be applied during the entirety of the at least one sensing interval. However, it is also possible that the test current or the test voltage are applied only during parts of the at least one sensing interval. Applying a comparatively low test current or test voltage to the light-emitting device provides the technical benefit that the light-emitting dissipates only a low power during sensing such that, during the sensing cyle, the light-emitting device maintains its temperature and does not further heat up.

Further, the test electrical energy may be adapted for that the light-emitting device emits light only at very low intensity and/or stays dark during the at least one sensing interval. For example, the test current, $I_{test}$, and/or test voltage, $U_{test}$, may lead to zero, vanishing or negligible light emission during the at least one sensing interval. This provides the benefit of not disturbing emission of light having the target brightness and colour since only operation in the on-interval recognizably contributes to the perceived light stream. In other words, operation during the sensing interval does not disturb normal operation during the on-interval. In particular, the control of the brightness and/or the colour of the emitted light is not disturbed. It could also be said that the vanishing or very low intensity of the light emitted during the one or more sensing intervals is not recognized by the human eye. Even if light of a very low intensity is emitted during the at least one sensing interval, the sensing interval may be comparatively short in comparison to the on-interval such that the low intensity during the sensing interval does almost not contribute to the overall light stream, which is mainly determined by the light stream emitted during operation in the on-interval. For example, if no light is emitted during the at least one sensing interval even if the test current, $I_{test}$, or the test voltage, $U_{test}$, is applied, the test current, $I_{test}$, or test voltage, $U_{test}$, may be applied

more frequently than if light of low intensity is emitted during application of the test current, $I_{test}$, or test voltage, $U_{test}$, during the at least one sensing interval.

Also, the test electrical energy may be adapted for ensuring linear behavior of voltage and/or current across the light-emitting device related to temperature of the light-emitting device. Linear behavior of two parameters means that the two parameters are proportional to each other. Hence, the relationship between the two parameters may be parametrized in a simple way, namely by using a slope and an intercept. For example, linear behavior of voltage and/or current across the light-emitting device with respect to its temperature provides the advantage that, when current and/or voltage are measured, the temperature could be determined in a comparatively simple way. However, if the power dissipated in the light-emitting device when applying the electrical energy, becomes too large, current and/or voltage across the light-emitting device are not anymore linked in a linear way to the temperature of the light-emitting device. Thus, it could be said that, to ensure linear behavior, the test electrical energy must be limited in order to achieve a reliable temperature estimate.

The above-mentioned need is also fulfilled by an electronic device for determining a temperature of a light-emitting device according to the current invention. The electronic device for determining the temperature of a light-emitting device comprises at least one light-emitting device. Further, the electronic device according to the current invention comprises a driving unit operating the at least one light-emitting device during an on-interval and during an off-interval. The driving unit is adapted to apply the operating electrical energy to the at least one light-emitting device during the on-interval. The electrical energy may be a current and/or a voltage. If more than one light-emitting device is included in the electronic device, the driving unit may provide individual operating electrical energies to each light-emitting device. Further, the electronic device may comprise a test electrical energy generating unit, which applies the test electrical energy, e.g., a test current and/or test voltage to the light-emitting device. If more than one light-emitting device is included in the electronic device, the test electrical energy generating unit may apply electrical energy individually to each light emitting device. The test electrical energy generating unit may be a part of the driving unit. Alternatively, the test electrical energy generating unit may be located outside of the driving unit. Also, the electronic device for determining the temperature of a light-emitting device according to the current invention comprises a measurement unit for measuring, during at least one sensing interval, at least one electrical energy across the at least one light-emitting device, wherein the at least one sensing interval is included in the off-interval and wherein each of the at least one sensing interval has a duration equal to or less than a duration of the off-interval. The measurement unit may record the measured electrical energies across the one or more light-emitting devices. Hence, information flows from the light-emitting devices to the measurement unit in response to that the test electrical energy generating unit drives the light-emitting devices in respective sensing intervals. Finally, the electronic device for determining the temperature of the light-emitting device according to the current invention comprises a determination unit for determining at least one temperature value of the at least one light-emitting device based on the measured at least one electrical energy. The determination unit is responsible for estimating the temperature values for the one or more light-emitting devices from the values of the electrical energy measured by the measurement unit. Hence, it is possible that the determination unit includes a microcontroller which transforms electrodynamic quantities as, e.g., voltages and/or currents, into thermodynamical quantities, e.g., the temperature, based on the methods described above, e.g., using analytical formulas, interpolation of indexed lists or lookup-tables, or trained neural networks. The electronic device may additionally include an averaging and diagnosing unit. The averaging and diagnosing unit may be a part of the determination unit or may be independent of the determination unit. The averaging and diagnosing unit may comprise a microcontroller. The microcontroller could average one or more sets of measured electrical energies and/or one or more sets of estimated temperature values to form one or more mean and/or one or more median values for the measured electrical energy and the temperature, respectively. Furthermore, the microcontroller could diagnose faulty values in the one or more sets of measured electrical energies and/or the one or more sets of estimated temperature values. This diagnosing could make use of comparing at least one value of the one or more sets of measured electrical energies to the one or more mean and/or one or more median values for the measured electrical energy. Likewise, the diagnosing could make use of comparing at least one value of the one or more sets of estimated temperatures to the one or more mean and/or one or more median values for the temperature. Thus, it could also be said that, by statistically analyzing pluralities of measured electrical energies and/or estimated temperatures, outliers in these pluralities are identified. These outliers could then be discarded or separately processed to obtain mean and/or median values with higher accuracy.

The driving unit may comprise at least one voltage source and/or current source to provide the desired operating electrical energy to the light-emitting device. Similarly, the test electrical energy generating unit may comprise at least one voltage source and/or current source to provide the desired test electrical energy to the light-emitting device. It could also be said that the driving unit may comprise a current source to provide an operating current and/or a voltage source to provide an operating voltage. Likewise, it could be said that the test electrical energy generating unit may comprise a current source to provide a test current and/or a voltage source to provide a test voltage. Both, the driving unit and the test electrical energy generating unit, may have respective input interfaces over which information is received that instructs the driving unit and the test electrical energy generating unit to provide the desired operating electrical energy and test electrical energy, respectively. Furthermore, the driving unit and the test electrical energy generating unit may comprise at least one output interface for handing over the operating electrical energy and the test electrical energy, respectively, to the light-emitting device. The measurement unit may include a differential amplifier to measure at least one electrical energy occurring across the light-emitting device. The differential amplifier may compare the at least one electrical energy occurring across the light-emitting device to one or more reference physical quantities. Furthermore, the measurement unit may include a processor. The processor may process data generated by the differential amplifier in response to the measured at least one electrical energy. In addition, the measurement unit may include at least one input interface to sense the at least one electrical energy and at least one output interface to deliver the measurement of the at least one electrical energy. The output interface may deliver data from the processor or from the differential amplifier, or both. The data may be representative of the electrical energy across the light-emitting device. The determination unit may comprise an input interface to receive data from the measurement unit. For example, the input interface of the determination unit may receive the data output at the output interface of the measurement unit. The determination unit may comprise a processor to process the data received at the input interface. In addition, the determination unit may comprise a memory. For example, the processor may use a correlation between values of the electrical energy occurring across the light-emitting device and values of the temperature of the light-emitting device to infer one or more temperature values from the data received at the input interface. Furthermore, the determination unit may comprise an output interface for outputting the one or more temperature values.

BRIEF DESCRIPTION OF THE DRAWINGS

In the following further advantages and details of the invention will become apparent from the detailed description of the figures. It shall be understood that none of the elements shown shall be regarded to be limiting and any software/hardware element or module which performs the respective described functionality shall be encompassed.

FIG. 1          shows a flow diagram of a method according to the invention;

FIG. 2a          shows a schematic view of a single on-interval and a single-off interval, together with a single sensing interval, which is placed in the middle of the off-interval according to the invention;

FIG. 2b  shows a schematic view of another embodiment of a single on-interval and a single-off interval, together with a single sensing interval, wherein the sensing interval is placed at the beginning of the off-interval, according to the invention;

FIG. 2c  shows a schematic view of another embodiment of a single on-interval and a single-off interval, together with a single sensing interval, wherein the sensing interval is placed at the end of the off-interval, according to the invention; and

FIG. 2d  shows a schematic view of another embodiment of a single on-interval and a single-off interval, together with a plurality of sensing intervals, according to the invention;

FIG. 3a  shows a schematic view of a repeated scheme according to the invention, in which each off-interval includes one sensing interval; and

FIG. 3b  shows a schematic view of another embodiment of a repeated scheme according to the invention, in which only a periodic subset of off-intervals includes one sensing interval;

FIG. 4  shows a schematic view of an exemplary dependency of the voltage across a light-emitting device as a function of the temperature of the light-emitting device according to the invention; and

FIG. 5  shows an exemplary block diagram of the electronic device according to the invention.

DETAILED DESCRIPTION

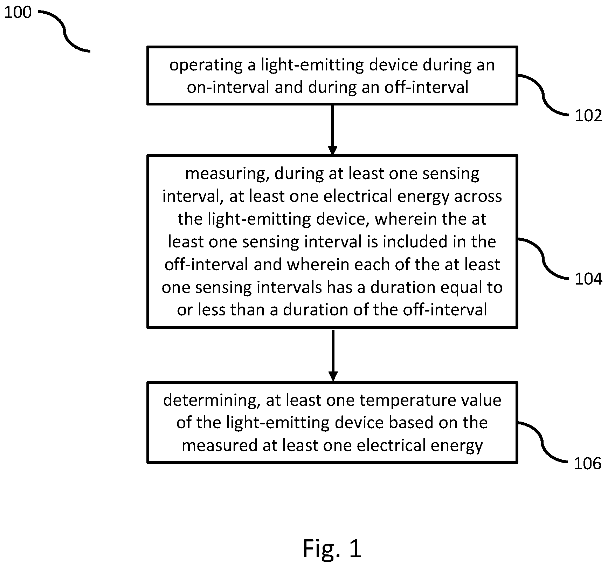

Figure 1 shows a method 100 for determining the temperature of a light-emitting device according to the invention. The method 100 includes the steps of operating 102 a light-emitting device during an on-interval and during an off-interval, measuring 104, during at least one sensing interval, at least one electrical energy across the light-emitting device, wherein the at least one sensing interval is included in the off-interval and wherein each of the at least one sensing intervals has a duration equal to or less than a duration of the off-interval, and determining 106, at least one temperature value of the light-emitting device based on the measured at least one electrical energy.

Method 100 for determining the temperature of the light-emitting may be performed by an electronic device according to the invention. For example, the light-emitting device may be operated 102 by a driving unit of the electronic device. Hence, the driving unit may supply an operating electrical energy to the light-emitting device. In addition, a test electrical energy generating unit of the electronic device may supply a test electrical energy to the light-emitting device. A measurement unit of the electronic device may measure 104, during the at least one sensing interval, the at least one electrical energy across the light-emitting device. From the measured 104 at least one electrical energy, a determination unit of the electronic device may determine 106 the at least one temperature value of the light-emitting device.

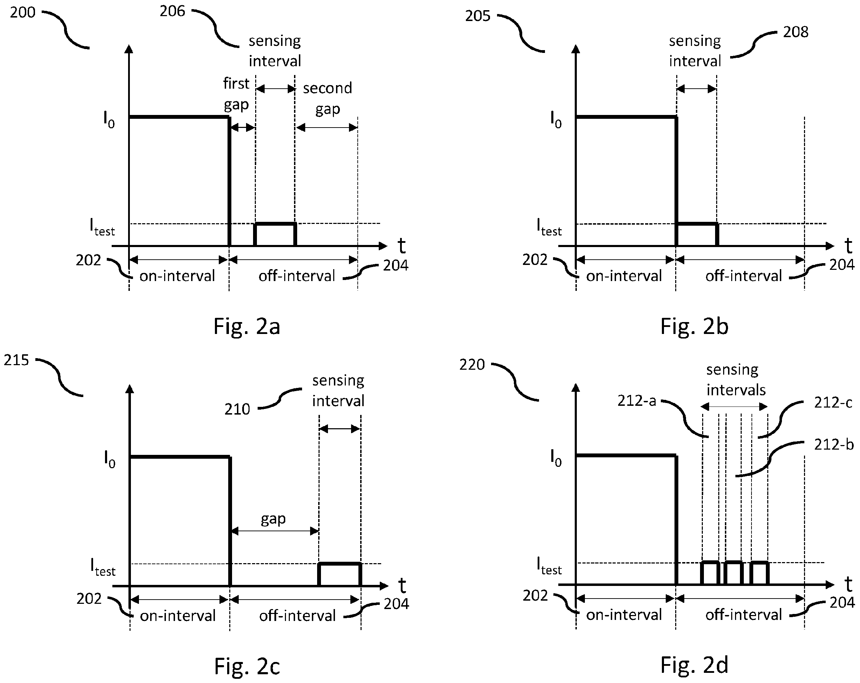

Figure 2a depicts a time diagram 200 comprising an on-interval 202, an off-interval 204 and a sensing interval 206. The on-interval 202 is characterized by a first length, the off-interval 204 is characterized by a second length and the sensing interval 206 is characterized by a third length. In general, the sensing interval 206 is included in the off-interval 206. Hence, the third length is equal to or smaller than the second length. In an exemplary way, in Figure 2a, the sensing interval 206 is shown to be located in the interior of the off-interval 204. Hence, in the example of Figure 2a, the third length is smaller than the second length. Thus, a first gap is formed between the end of the on-interval 202 and the beginning of the sensing interval 206, and a second gap is formed between the end of the sensing interval 206 and the end of the off-interval 204.

During the on-interval 202 the light-emitting device may be supplied with an operating current and/or voltage. In Figure 2a, a constant operating current, $I_o$, is shown. However, a person skilled in the art knows that any light-emitting device may also be driven by a time-dependent operating current, $I_o(t)$. This leads to emission of light with the desired brightness and colour during the on-interval 202. In other words, the supply with an operating current, $I_o(t)$, during the on-interval 202 may have the effect of light emission with a desired time-dependent radiant power, $P(t)$. At the onset of the off-interval 204, the operating current and/or voltage is considerably reduced, potentially even down to zero. Hence, the time dependent radiant power, $P(t)$, falls to a lower value, potentially even to zero, too. The radiant power, $P(t)$, may lag the operating current, $I_o(t)$. Hence, the first gap may be used to allow for adjustment and relaxation of the radiant power to the mode of operation during the sensing interval. During the sensing interval 206 a comparatively low test current, $I_{test}(t)$, is applied to the light-emitting device, which leads to a new radiant power, $P(t)$. In the example of Figure 2a, a constant test current, $I_{test}(t)$ = *const.*, is shown. However, this shall not be considered to be limiting the current disclosure since any time-dependent test current, $I_{test}(t)$, applied during the sensing interval (206) shall also be comprised. The light energy emitted during the sensing interval 206 may be either vanishing, or comparatively low such that the emitted light is not perceivable or only perceivable as a glim by the human eye. In a more quantitative way, the on-interval 202 distinguishes over the off-interval 204 by that the energy of the light emitted during the on-interval 202 is considerably larger than the energy of the light emitted during the off-interval 204. Using the radiant power, P(t), it might be said that the following inequality holds with regards to the energy of the emitted light over the on-interval 202 and the off-interval 204:

$$\int_{on-interval} P(t)dt \gg \int_{off-interval} P(t)dt$$

One or more voltage values, U, are measured across the light-emitting device, when the test current, $I_{test}(t)$, is applied during the sensing interval 206. The one or more voltage values, U, may comprise a forward voltage, $U_F$, measured over the light-emitting device. One or more temperature, T, values for the temperature of the light-emitting device are determined from the one or more voltage values, U, using the method described above. For instance, a correlation between forward voltage and temperature may be exploited to infer a temperature from a given measured forward voltage. The correlation could be evaluated using interpolation of a look-up table of temperatures and forward voltages. The interpolation may be global linear interpolation, piecewise local linear interpolation, Fourier approximation or polynomial interpolation, e.g., spline interpolation, as described above. In Figure 2a, the second gap following the sensing interval 206 may be used for calculating, by making use of the determined temperature values, the operating current, $I_o(t)$, for obtaining a desired radiant power, P(t), in a next on-interval following the off-interval 204 depicted in Figure 2a.

Figure 2b depicts an on-interval 202, an off-interval 204 and a sensing interval 208 according to a second embodiment 205 of the invention. In Figure 2b, the sensing interval 208 is located at the beginning of the off-interval 204. Therefore, the temperatures determined during the sensing interval 208 of Figure 2b may constitute an estimate of the temperature of the light-emitting device immediately at the end of the foregoing on-interval 202. In other words, locating the sensing interval 208 at the beginning of the off-interval 204 yields to one or more temperature measurements which best characterize the temperature of the light-emitting device at the time of maximum heating during operation, namely at the end of the on-interval 202 when a maximum of energy has been disposed in the light-emitting device. Such a temperature measurement may be used to supervise operation the light-emitting device, to issue a warning when maximum allowed temperatures are exceeded and to act proactively by, e.g., readjusting the operating electrical energy. Furthermore, aging effects of the light-emitting device due to operation in the on-interval 202 might be quantified based on the determined temperatures.

Figure 2c depicts an on-interval 202, an off-interval 204 and a sensing interval 210 according to a third embodiment 215 of the invention. In Figure 2c, the sensing interval 210 is located at the end of the off-interval 204. During the gap formed between the end of the on-interval 202 and the beginning of the sensing interval 210, the light-emitting device may lower its temperature and cool down since, due to the vanishing operating current, no further energy is disposed in the light-emitting device during the gap. Hence, the one or more temperatures determined during the sensing interval 210 of Figure 2c constitute an estimate of the temperature of the light-emitting device after thermal relaxation, at the onset of the next on-interval following the off-interval 204 depicted in Figure 2c. These temperatures may be used to compensate for temperature effects when adjusting the operating electrical energy of the light-emitting device for the next on-interval.

Figure 2d depicts an on-interval 202, an off-interval 204 and a plurality of sensing intervals 212-a, 212-b, 212-c according to a fourth embodiment 220 of the invention. The plurality of sensing intervals 212-a, 212-b, 212-c is distributed over the off-interval 204. In this way, a plurality of temperature measurements is obtained which characterize the temperature of the light-emitting device at different points of time during the off-interval 204. In particular, the temperature determined during a first sensing interval 212-a located at the beginning of the off-interval 204 could be used as an estimate of the temperature of the light-emitting device at the end of the on-interval 202, while the temperature determined during a third sensing interval 212-c located at the end of the off-interval 204 could be used as an estimate of the temperature of the light-emitting device directly at the onset of the next on-interval. The temperature determined during a second sensing interval 212-b located in the middle of the off-interval 204 could be used to estimate the velocity of temperature relaxation of the light-emitting device. Instead of one second sensing interval 212-b located in the middle of the off-interval 204, a plurality of sensing intervals located between the first sensing interval 212-a and the third sensing interval 212-c could be used (not shown). During this plurality of sensing intervals, a plurality of associated temperatures could be determined. Determining a large number of temperature values has the technical advantage that the velocity of temperature relaxation is sampled with high temporal resolution. Also, the temperature values could be averaged to result in one or more mean temperature estimates with a higher statistical stability. Furthermore, it would be possible that wrong temperature measurements among the plurality of temperature measurements are detected, e.g., via outlier detection, such that only those temperature measurements, which have passed a quality test, are used to establish the velocity of temperature relaxation. Based on the velocity of temperature relaxation of the light-emitting device, the length of the off-interval 204 may be adjusted. For example, the length of the off-interval 204 may be adjusted in such a way that the light-emitting device has cooled down to a desired temperature at the end of the off-interval 204. The lengths of the gaps between the individual sensing intervals 212-a, 212-b, 212-c may be adjusted to avoid that the light-emitting device heats up due to the energy dissipated by supplying the test current. In other words, the gaps may be chosen in such a way that the heat loss during each gap is larger or equal to the heat gain during the preceding sensing interval of the plurality of sensing intervals 212-a, 212-b, 212-c. In this way, each of the gaps compensates the heating of the light-emitting device during a corresponding sensing interval.

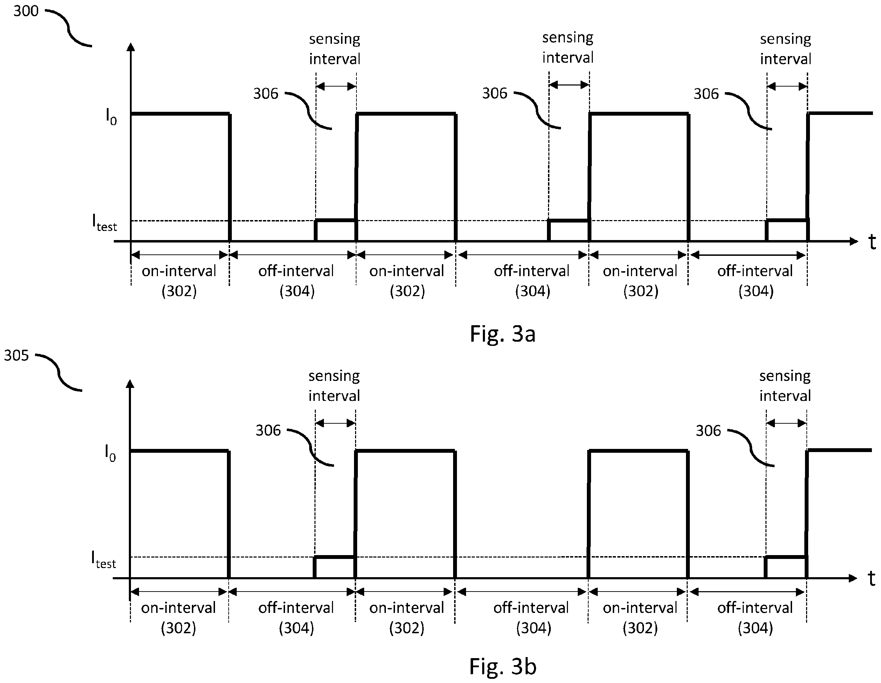

Figures 3a and 3b depicts a fifth and a sixth embodiment 300 and 305 of the invention, for which the on-intervals 302 and off-intervals 304 alternate. Each on-interval 302 and each off-interval 304 of Figures 3a and 3b may be structured in a similar way as the on-intervals 202 and the off-intervals 204 of Figures 2a-2d above. For simplicity, the off-intervals 304 of Figure 3a have been depicted in a similar way as the off-intervals 204 of Figure 2c, i.e., each off-interval 304 includes only one sensing interval 306 at the end of the respective off-interval 304. Although not shown, the stream of on-intervals 302 and off-intervals 304 depicted in Figures 3a and 3b may continue in a repeated manner beyond the third off-interval 304. Thus, the on-intervals 302 and off-intervals 304 may occur periodically. In this way, continuous operation with delivery of light of the desired brightness and colour is ensured, while streams of temperature measurements are generated that could be used in a repeated manner for the purposes described above in connection with Figures 2a-2d. For example, the temperature measurements in each of the sensing intervals 306 may be used repeatedly to adjust the operating currents in the respective on-intervals 302 following the respective sensing interval 306. As depicted in Figure 3b, the sensing intervals 306 may occur only in a subset of the plurality of off-intervals 304, e.g., every second off-interval 304. However, the sensing intervals 306 may also occur with other periodicities in the subset of the plurality of off-intervals 304, e.g., every 10th or every 100th off-interval 304, or even aperiodically, i.e., without any periodicity at all (not shown). In other words, the plurality of off-intervals 306 may be sparser as compared to the plurality of off-intervals 304. In this way, those off-intervals 304, which do not contain any sensing interval 306 or fewer sensing intervals 306 than other off-intervals 304, do not trigger calculation of temperature estimates at a microcontroller, which lowers the computational burden by reducing the number of operations at the microcontroller.

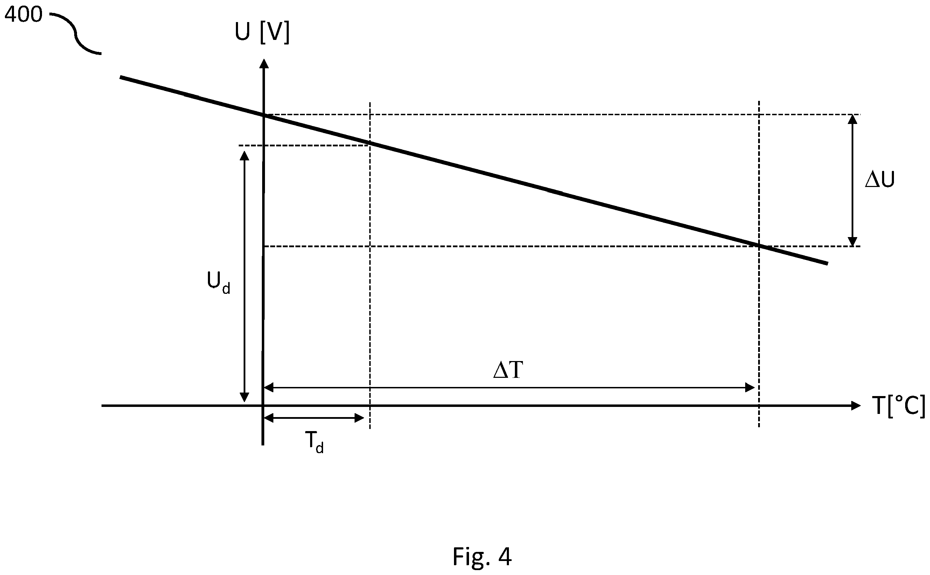

Figure 4 depicts an embodiment of a correlation 400 between temperature, T, of the light-emitting device and voltage, U, across the light-emitting device according to the current invention. The voltage, U, across the light-emitting device may be the forward voltage measured over the light-emitting device, as described above. The correlation 400 defines a relationship between voltage, U(T), and temperature, T. In the case of Figure 4, this relationship is linear. However, also non-linear functions describing the relationship between voltage, U(T), and temperature, T, may occur (not shown). The correlation 400 is characterized by a dedicated temperature, $T_d$, for which a dedicated voltage, $U_d$, is measured, and a temperature gradient, $\Delta U/\Delta T$, which describes the slope of the correlation 400. These values unambiguously determine the linear correlation 400 shown in Figure 4. The dedicated temperature, $T_d$, and the temperature gradient, $\Delta U/\Delta T$, of Figure 4 could be determined by applying linear regression to calibration measurements of temperature and voltage for a given light-emitting device. When a measured voltage, U, is given, the gradient, $\Delta U/\Delta T$, the dedicated temperature, $T_d$, and the dedicated voltage, $U_d$, may be used to find the temperature, T(U), according to the equation:

$$T(U) = T_d + \Delta T/\Delta U{*}(U\text{-}U_d) \qquad [{*}].$$

Non-linear correlations (not shown) may be approximated using piecewise linear interpolation, polynomial or spline approximation, as described above.

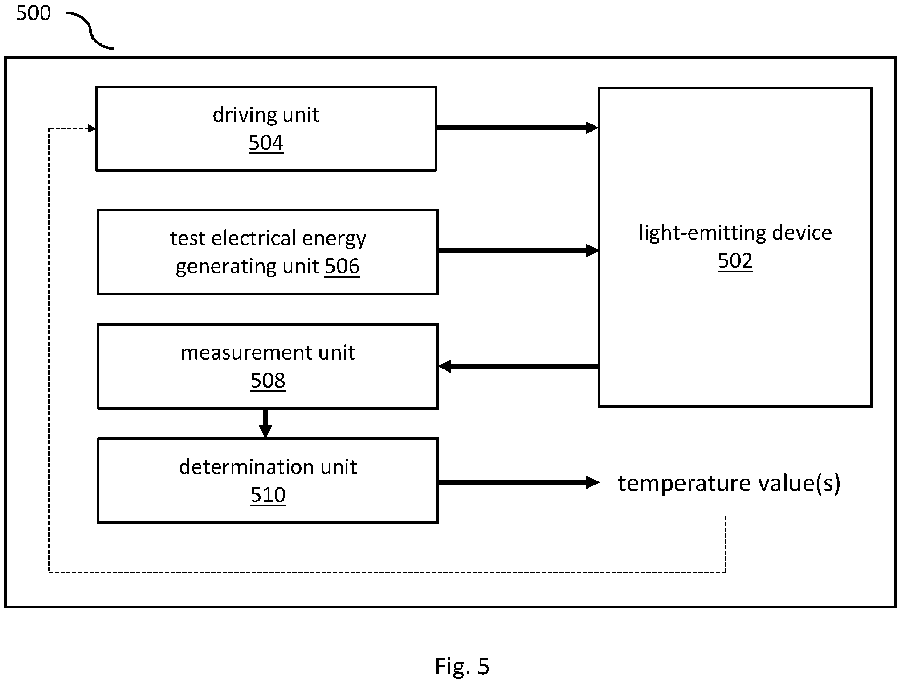

Figure 5 depicts an embodiment of an electronic device or apparatus 500 for determining the temperature of a light-emitting device according to the current invention. The electronic device 500 may perform method 100 depicted in Figure 1 and described above. In the here shown embodiment example, the electronic device 500 encompasses a light-emitting device 502. It is however also contemplated that the electronic device 500 is implemented separately to the light-emitting device 502. The electronic device 500 may thereby be connected to one light-emitting device 502 or to several light-emitting devices (here not shown). The electronic device 500 may thereby be located close to the at least one light-emitting device 502 or even spaced apart therefrom, for example be part of a controller. In the here shown embodiment example, electronic device 500 further comprises a driving unit 504, a test electrical energy generating unit 506, a measurement unit 508 and a determination unit 510. The light-emitting device 502 may comprise a light-emitting diode, LED. It is also possible that light-emitting device 502 comprises a plurality of light-emitting devices, e.g. a plurality of light-emitting diodes, LEDs (not shown). The light-emitting device 502 emits light of a desired brightness and colour, when supplied with a corresponding operating electrical energy. The driving unit 504 is adapted to supply operating electrical energy to the light-emitting device 502 during on-intervals according to one or more of the temporal schemes depicted in Figures 2a-2d and/or in Figures 3a and 3b. Thus, the driving unit 504 is responsible for steering the light-emitting device 502 during normal operation according to a driving algorithm. If more than one light-emitting device 502 is included in the electronic device 500, the driving unit 504 may apply a plurality of different steering algorithms, wherein a respective of the different steering algorithms is applied to each individual light-emitting device (not shown). For this, the driving unit 504 interfaces with the light-emitting device 502. The interface enables application of the operating electrical energy to the light-emitting device 502. The test electrical energy generating unit 506 is responsible for applying a test electrical energy to the light-emitting device 502 according to one or more of the sensing intervals of Figures 2a-2d, 3a or 3b. An interface between the test electrical energy generating unit 506 and the light-emitting device enables the application of the test electrical energy. The test electrical energy generating unit 506 may comprise a variable current source and/or a variable voltage source, which supply a test current and/or a test voltage. The test electrical energy generating unit 506 may be separated from the driving unit 504 or included in the driving unit 504. The measurement unit 508 measures one or more electrical energies occurring across the light-emitting device 502 during the one or more sensing intervals. To sense the electrical energies, the measurement unit 508 interfaces with the light-emitting device 502. The measurement unit 508 may include a differential amplifier, which amplifies the one or more electrical energies measured over the light-emitting device 502. Further, the measurement unit 508 may comprise an analogue-to-digital, AD, converter system, into which the one or more amplified electrical energies are fed, and which converts the one or more amplified electrical energies into digital format. Finally, the measurement unit 508 may include a processor, which turns the one or more amplified electrical energies in digital format into respective forward voltage values. The measurement unit 508 interfaces with the determination unit 510 such that the respective forward voltage values are known at the determination unit 510. The determination unit 510 may comprise a processor which turns the forward voltage values into temperature values, as described above. The determined temperature values may then be fed back (dotted arrow) to the driving unit 504 in order to adapt the operating electrical energy to the temperature of the light-emitting device 502. For example, the driving unit 504 might be adapted to compensate the operating electrical energy for temperature effects on the brightness and colour of the light-emitted by the light-emitting device 504 and adjust the operating electrical energy, accordingly. Likewise, the driving unit 504 might be adapted to take an action, when the temperature of the light-emitting device 502 becomes intolerably high. In this case, the driving unit 504 might reduce the operating electrical energy or shorten the duration of a current on-interval or one or more future on-intervals. The driving unit 504 might also issue a warning message, when the temperature exceeds a temperature limit.

Although specific hardware elements are described herein, this shall not be understood to be limiting and the invention shall also encompass other hardware elements, which are able to provide the same functionality as the ones described herein.

**Claims**

1. A method for determining the temperature of a light-emitting device (502), the method comprising:

   operating (102) the light-emitting device (502) during an on-interval and during an off-interval;
   measuring (104), during at least one sensing interval, at least one electrical energy across the light-emitting device (502), wherein the at least one sensing interval is included in the off-interval and wherein each of the at least one sensing intervals has a duration equal to or less than a duration of the off-interval; and
   determining (106), at least one temperature value of the light-emitting device (502) based on the measured at least one electrical energy.

2. The method of claim 1, wherein the at least one sensing interval is located at the beginning of the off-interval or at the end of the off-interval.

3. The method of any of the preceding claims, wherein the on-interval is one of a plurality of on-intervals, and/or wherein the off-interval is one of a plurality of off-intervals.

4. The method of claim 3, wherein the plurality of on-intervals is periodic, and/or wherein the plurality of off-intervals is periodic.

5. The method of claims 3 or 4, wherein each off-interval of the plurality of off-intervals or wherein each off-interval of a subset of the plurality of off-intervals includes at least one sensing interval.

6. The method of any of the preceding claims, wherein the operating the light-emitting device (502) comprises:

   applying, during the on-interval, an operating electrical energy to the light-emitting device (502); and
   reducing, during the off-interval, the operating electrical energy.

7. The method of claim 6, wherein, during at least parts of the off-interval, the operating electrical energy is reduced to zero.

8. The method of any of the preceding claims, wherein the determining of the at least one temperature value comprises:
   estimating the at least one temperature value based on a correlation between temperatures of the light-emitting device (502) and electrical energies occurring across the light-emitting device (502).

9. The method of claim 8, further comprising:

averaging at least a part of the electrical energies before estimating the at least one temperature value based on the correlation; and/or averaging at least a part of the at least one temperature value after estimating the at least one temperature value based on the correlation.

10. The method of any of claims 8 and 9, wherein the correlation is based on: a temperature gradient and a dedicated voltage and/or current across the light-emitting device (502), wherein the dedicated voltage and/or current corresponds to the voltage and/or current at a dedicated reference temperature of the light-emitting device (502).

11. The method of claim 10, wherein the temperature gradient is the same for a set of light-emitting devices (502) having the same type as the light-emitting device (502).

12. The method according to any of the preceding claims, further comprising:
applying, during the at least one sensing interval, a test electrical energy to the light-emitting device (502).

13. The method of claim 12, wherein the test electrical energy is adapted for that the light-emitting device (502) emits light only at very low intensity and/or stays dark during the at least one sensing interval.

14. The method of claim 12 or 13, wherein the test electrical energy is adapted for ensuring linear behaviour of voltage and/or current across the light-emitting device (502) related to temperature of the light-emitting device (502).

15. An apparatus (500) for determining the temperature of a light-emitting device (502), the apparatus (500) comprising:

a driving unit (504) operating the at least one light-emitting device (502) during an on-interval and during an off-interval;
a measurement unit (508) for measuring, during at least one sensing interval, at least one electrical energy across the at least one light-emitting device (502), wherein the at least one sensing interval is included in the off-interval and wherein each of the at least one sensing interval has a duration equal to or less than a duration of the off-interval; and
a determination unit (510) for determining at least one temperature value of the at least one light-emitting device (502) based on the measured at least one electrical energy.

EP 4 543 145 A1

100

operating a light-emitting device during an
on-interval and during an off-interval

102

measuring, during at least one sensing
interval, at least one electrical energy across
the light-emitting device, wherein the at
least one sensing interval is included in the
off-interval and wherein each of the at least
one sensing intervals has a duration equal to
or less than a duration of the off-interval

104

determining, at least one temperature value
of the light-emitting device based on the
measured at least one electrical energy

106

Fig. 1

Fig. 2a

Fig. 2b

Fig. 2c

Fig. 2d

EP 4 543 145 A1

Fig. 3a

Fig. 3b

Fig. 4

EP 4 543 145 A1

Fig. 5

Europäisches Patentamt

European Patent Office

Office européen des brevets

# EUROPEAN SEARCH REPORT

**Application Number**

EP 23 20 4931

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 264 171 B1 (DOMER STEVEN M [US]) 11 September 2012 (2012-09-11) * the whole document * | 1-15 | INV. H05B45/28 G01R31/26 <br><br> ADD. G01K7/01 H05B45/18 |

TECHNICAL FIELDS SEARCHED (IPC)

H05B
G01K
G01R

The present search report has been drawn up for all claims

| Place of search | Date of completion of the search | Examiner |
|---|---|---|
| Munich | 11 March 2024 | Waters, Duncan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 20 4931**

This annex lists the patent family members relating to the patent documents cited in the above-mentioned European search report.
The members are as contained in the European Patent Office EDP file on
The European Patent Office is in no way liable for these particulars which are merely given for the purpose of information.

**11-03-2024**

| Patent document cited in search report | Publication date | Patent family member(s) | Publication date |
|---|---|---|---|
| US 8264171 B1 | 11-09-2012 | NONE | |

For more details about this annex : see Official Journal of the European Patent Office, No. 12/82

EPO FORM P0459